(19) Europäisches Patentamt / European Patent Office / Office européen des brevets

(11) **EP 2 245 632 B1**

(12) **FASCICULE DE BREVET EUROPEEN**

(45) Date de publication et mention de la délivrance du brevet:
**07.09.2011 Bulletin 2011/36**

(21) Numéro de dépôt: **09712534.8**

(22) Date de dépôt: **16.02.2009**

(51) Int Cl.:
**G11C 11/412** *(2006.01)*     **G11C 11/419** *(2006.01)*

(86) Numéro de dépôt international:
**PCT/EP2009/051819**

(87) Numéro de publication internationale:
**WO 2009/103687 (27.08.2009 Gazette 2009/35)**

(54) **CELLULE MÉMOIRE SRAM À TRANSISTORS DOUBLE GRILLE DOTEE DE MOYENS POUR AMELIORER LA MARGE EN ECRITURE**

SRAM-SPEICHERZELLE AUF BASIS VON DOPPELGATE-TRANSISTOREN MIT MITTEL ZUR ERWEITERUNG EINES SCHREIBBEREICHS

SRAM MEMORY CELL BASED ON DOUBLE-GATE TRANSISTORS, PROVIDED WITH MEANS FOR IMPROVING THE WRITE MARGIN

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **18.02.2008 FR 0851027**

(43) Date de publication de la demande:
**03.11.2010 Bulletin 2010/44**

(73) Titulaire: **Commissariat à l'Énergie Atomique et aux Énergies Alternatives
75015 Paris (FR)**

(72) Inventeurs:
• **THOMAS, Olivier**
  **F-38420 Revel (FR)**
• **GIRAUD, Bastien**
  **F-83110 Sanary sur Mer (FR)**

(74) Mandataire: **Ilgart, Jean-Christophe et al
BREVALEX
95 rue d'Amsterdam
75378 Paris Cedex 8 (FR)**

(56) Documents cités:
**US-A- 5 793 671     US-A- 5 852 572
US-A1- 2007 139 072     US-B1- 6 529 400**

**Description**

**DOMAINE TECHNIQUE**

L'invention se rapporte au domaine des mémoires à accès aléatoires RAM (RAM pour « Random Access Memory »), et concerne en particulier une structure particulière de cellule mémoire statique à accès aléatoire dotée de transistors à double-grille.

Une telle structure est notamment dotée de moyens pour améliorer la marge en écriture (WM) de la cellule.

L'invention vise également une mémoire comprenant une pluralité de telles cellules.

**ÉTAT DE LA TECHNIQUE ANTÉRIEURE**

Une cellule mémoire SRAM classique (SRAM pour « Static Random Access Memory » ou mémoire vive statique) comprend généralement deux inverseurs connectés selon une configuration dite de bascule ou « flip-flop » et deux transistors d'accès connectés à des lignes dites de bit, et commandés par une ligne de mot.

Les caractéristiques recherchées pour une cellule mémoire sont :

- une bonne stabilité lors des différentes opérations : de lecture, d'écriture, de rétention, effectuées sur la cellule,
- un courant de conduction ou de charge le plus important possible pour donner à la cellule une vitesse de fonctionnement élevée,
- un courant en rétention le plus faible possible afin de minimiser la puissance consommée statique,
- une taille de cellule minimale pour permettre de réaliser une mémoire avec une densité d'intégration de cellules importante.

Les deux premiers critères sont difficiles à concilier avec le dernier et amènent les concepteurs de mémoires à faire des compromis en fonction des applications visées.

Les cellules SRAM à six transistors appelées cellules « 6T », offrent un bon compromis entre tous les critères précités.

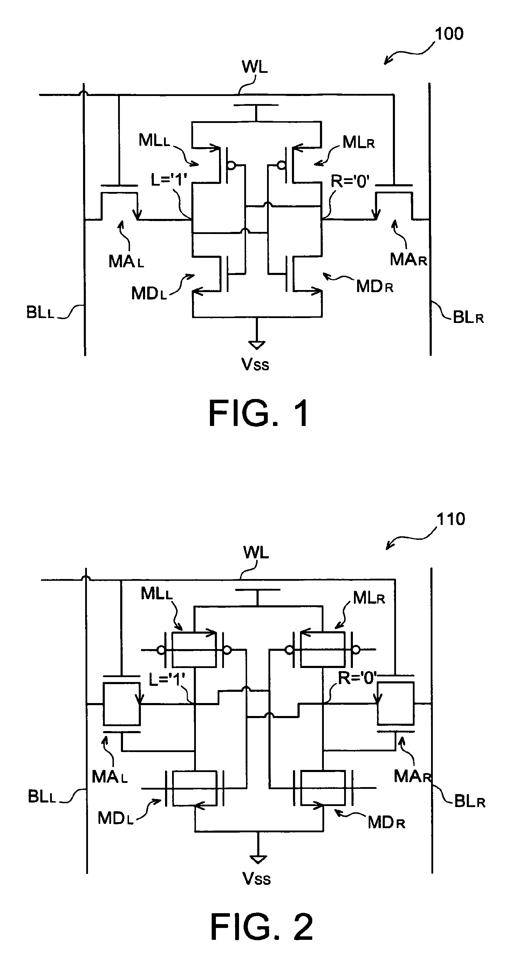

Sur la figure 1, une cellule 100 d'une mémoire SRAM conventionnelle est représentée. Cette cellule 100 est formée de 2 transistors de conduction $MD_L$ et $MD_R$ et de 2 transistors de charge $ML_L$ et $ML_R$, connectés selon une configuration dite de bascule ou « flip-flop », et de deux transistors d'accès $MA_L$ et $MA_R$ connectés respectivement à des lignes dites de bit $BL_L$ et $BL_R$, et commandés par une ligne de mot WL. Les transistors d'accès $MA_L$ et $MA_R$ sont prévus pour permettre l'accès ou bloquer l'accès respectivement à un premier noeud L chargé de conserver une première information logique, par exemple un '1' logique et à un deuxième noeud R chargé de conserver une deuxième information logique, complémentaire de la première information, par exemple un '0' logique.

On cherche à réduire la taille des transistors, ce qui a tendance à augmenter l'influence des courants de fuite liés notamment aux effets de canaux courts (SCE pour « Short Channel Effect ») ainsi que les dispersions des caractéristiques électriques entre les transistors, du fait du procédé de réalisation, en particulier des étapes de dopage. Il en résulte une dégradation des caractéristiques électriques des cellules mémoires formées de tels transistors.

Les performances des cellules mémoires se caractérisent à l'aide de plusieurs facteurs : la stabilité en lecture et en rétention, la consommation statique, le nombre maximal de cellules par colonne, la marge en écriture, le temps d'écriture, la sensibilité en écriture, la charge critique.

Deux facteurs revêtent une importance particulière : la marge en écriture (WM) et la marge au bruit en lecture (SNM), dans la mesure où pour les technologies de transistors avec des grilles de dimension critiques inférieures à 45 nm encore appelées « sub-45nm », il est de plus en plus difficile d'atteindre un bon compromis entre ces deux facteurs, en raison notamment de l'augmentation des variations de procédés et de l'augmentation des courants de fuite liés aux effets de canaux courts.

Une réalisation des cellules SRAM sur un substrat de type semi-conducteur sur isolant (SOI « Silicon on Insulator »), ou encore de cellules dotées de transistors à double-Grille (DG pour « double gate ») par exemple en technologie FET, peuvent permettre d'améliorer les caractéristiques électriques comparées à celles réalisées sur substrat massif en technologie communément appelée « BULK ».

Les technologies SOI et DG permettent d'obtenir un meilleur contrôle électrostatique du canal et génèrent moins de courant de fuite et moins d'effet de canaux courts (SCE). D'autre part, l'absence de dopants dans le substrat peut permettre de réduire de manière importante les dispersions électriques des transistors entre eux et des cellules entre elles.

La technologie DG offre également l'avantage d'un contrôle du transistor avec deux grilles, pouvant être contrôlée électriquement indépendamment l'une de l'autre. Ce double contrôle offre un degré de conception supplémentaire, qui permet d'optimiser les caractéristiques électriques des cellules.

Un mode de fonctionnement de la cellule 100 précédemment décrite, va à présent être donné.

Préalablement à la mise dans un mode de lecture, les lignes de bit $BL_{LL}$ et $BL_R$ de la cellule peuvent être chargées à un potentiel VDD. Pour cette cellule 100, le noeud le plus instable est généralement, celui qui contient l'information logique '0', par exemple le deuxième noeud R.

La stabilité au 1$^{er}$ ordre du deuxième noeud R peut être alors régie par l'inéquation suivante :

$$I_{G-LL} + I_{OFF-LR} + I_{ON-AR} \leq I_{ON-DR} \qquad (1)$$

avec : $I_{G-LL}$ le courant de grille du premier transistor de charge $ML_L$, $I_{OFF-LR}$ le courant de fuite du deuxième transistor de charge $ML_R$, $I_{ON-AR}$ et $I_{ON-DR}$ les courants de conduction respectifs du deuxième transistor d'accès $MA_R$ et du deuxième transistor de conduction $MD_R$.

En négligeant, les courants de grille et de fuite des transistors de charge, l'inéquation (1) précédente peut être écrite de la manière suivante :

$$I_{ON-AR} \leq I_{ON-DR} \qquad (2)$$

La stabilité en lecture de la cellule 100 dépend, au 1$^{er}$ ordre, d'un rapport $CR_{6T}$ de conductivité des transistors d'accès et de conduction dont les drains sont connectés au noeud de faible potentiel $CR_{6T} = \dfrac{(W/L)_{MD_R}}{(W/L)_{MA_R}}$, et au 2$^{ème}$ ordre, de la conductivité du transistor de charge dont la grille est reliée à ce même potentiel $(W/L)_{ML_L}$.

La marge en écriture de la cellule 100 correspond quant à elle, à une différence de tension minimum entre les lignes de bit $BL_L$ et $BL_R$ permettant l'écriture dans la cellule activée.

La marge en écriture de la cellule 100 dépend essentiellement d'un rapport noté $PR_{6T}$ tel que $PR_{6T} = \dfrac{(W/L)_{ML_L}}{(W/L)_{MA_L}}$ des transistors dont les drains sont reliés au noeud de stockage L='1'. Plus ce rapport diminue, plus la décharge du noeud de stockage L est aisée et plus la marge en écriture est améliorée.

Les rapports de conduction $CR_{6T}$ et $PR_{6T}$ relèvent de 2 critères antagonistes.

De nouvelles architectures de cellules mémoires SRAM ont été proposées afin d'améliorer l'un de ces deux critères ou de trouver un compromis entre ces deux critères.

Le document [1] (référencé à la fin de la présente description au même titre que les autres documents cités dans la présente) divulgue une cellule à 6 transistors double-grille réalisée en technologie finFET avec une longueur de grille de l'ordre de 22 nm.

Une telle cellule 110 est donnée sur la figure 2, et diffère de la cellule 100 précédemment décrite de par ses connections des grilles arrières des transistors d'accès $MA_L$ et $MA_R$ aux noeuds de stockage adjacents. La stabilité en lecture est ainsi améliorée. Cette contre-réaction permet également d'améliorer la stabilité en rétention mais dégrade fortement les performances lors des opérations d'écriture, et limite le nombre maximal de cellules implantables par colonne d'une matrice mémoire (la détermination d'un tel nombre étant définie par exemple dans le document [6]).

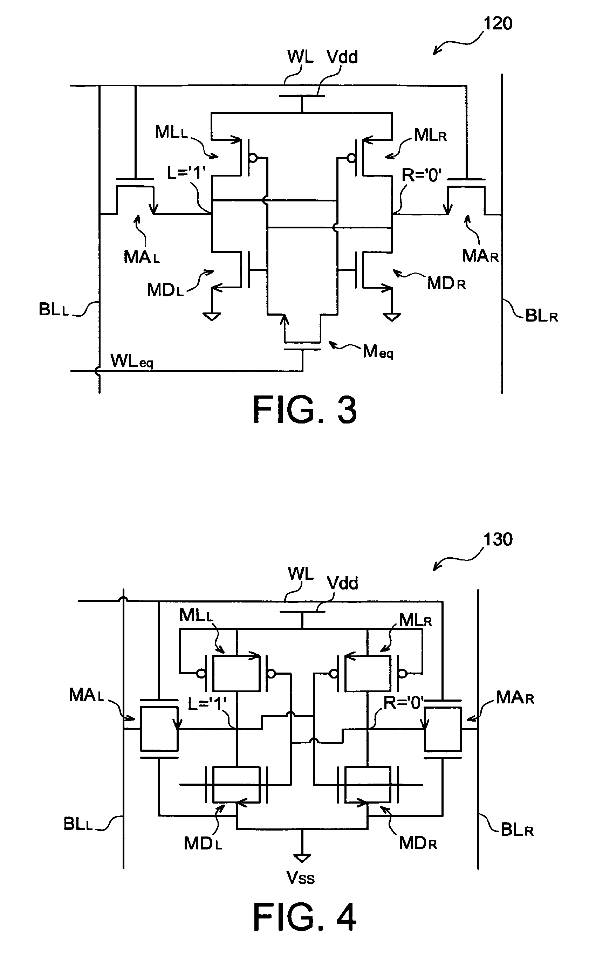

Une architecture à 7 transistors (7T) décrite dans le document [2], permet d'égaliser les potentiels des 2 noeuds de stockage L et R juste avant une opération d'écriture, grâce à un transistor supplémentaire Meq. Les électrodes drain/source de ce dernier sont connectées aux noeuds de stockage L et R. La marge en écriture ainsi que le temps pour réaliser une opération d'écriture sont améliorés par rapport aux cellules précédemment décrites. Sur la figure 3, une telle cellule 120 est représentée. Elle présente pour inconvénients : notamment une augmentation de la surface occupée et une complexité de commande accrue.

Une variante de cellule mémoire SRAM 6T réalisée en technologie SOI et double grille, a également été présentée dans le document [3]. La figure 4 représente un exemple d'une telle cellule 130, dans laquelle les grilles arrière des transistors d'accès sont reliées à un potentiel VSS afin de diminuer le courant de conduction des transistors d'accès. La condition de stabilité donnée précédemment par l'inéquation (2) est donc améliorée. Les grilles arrière des transistors de charge $ML_L$ et $ML_R$, sont connectées à une alimentation VDD, ce qui permet d'améliorer l'opération d'écriture en diminuant la conduction des transistors de charge. Néanmoins, cela a également pour effet de diminuer la stabilité au second ordre, en dégradant le maintien du noeud L.

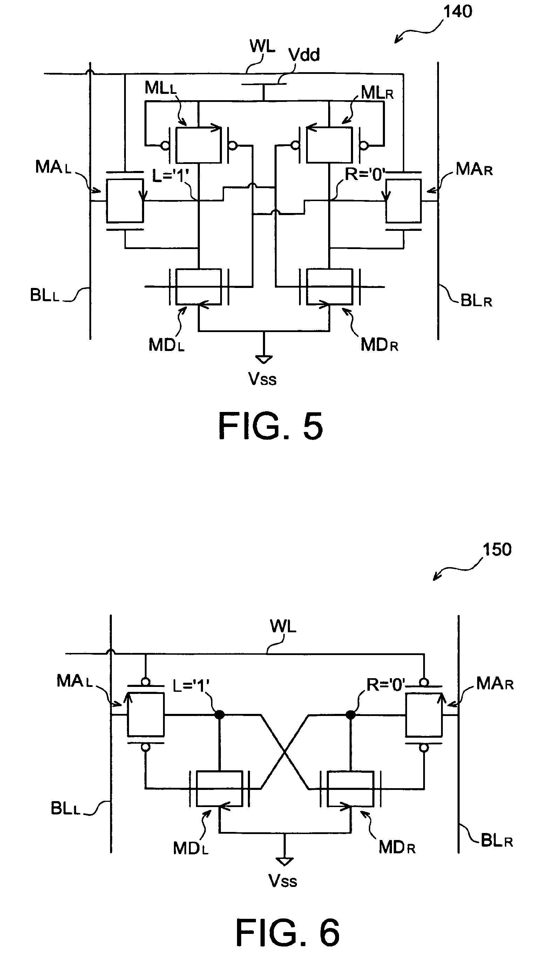

Une autre cellule 140, à 6 transistors et réalisée en technologie double grille est donnée sur la figure 5. Cette cellule 140 est présente une marge en écriture améliorée par rapport à la cellule 110.

Une telle cellule 140 possède une stabilité améliorée grâce à des contre-réactions entre les grilles arrières des transistors d'accès $MA_L$, $MA_R$ et les noeuds de stockages L et R adjacents. L'opération d'écriture est améliorée de la même manière que la cellule 130 précédemment décrite. En revanche, la stabilité au second ordre est dégradée par rapport à la cellule 6T double grille référencée 110 et décrite précédemment en liaison avec la figure 3.

Par rapport à la cellule 100 conventionnelle, le nombre maximal de cellules par colonne, le temps d'écriture et la marge en écriture des cellules 130 et 140 ont été détériorés.

Des cellules à forte densité d'intégration à 4 transistors (4T) ont également été mises en oeuvre et permettent, quant à elles, d'obtenir une très bonne marge en écriture.

Sur la figure 6, une cellule 150 à 4 transistors double grille est représentée. Cette cellule 150 est formée de 2 transistors de conduction $MD_L$ et $MD_R$, et de deux transistors d'accès $MA_L$ et $MA_R$. Une telle cellule 150 ne comporte pas de transistor de charge.

Sur la figure 7, une variante de cellule 160 à 4 transistors double grille est donnée. Cette cellule 160 est formée de 2 transistors de charge $ML_L$ et $ML_R$, et de deux transistors d'accès $MA_L$ et $MA_R$. Cette cellule 160 ne comporte, quant à elle, pas de transistor de conduction.

De telles cellules 4T présentent un compromis de stabilité rétention - lecture beaucoup moins intéressant que les cellules 6T. Par ailleurs, une cellule 4T en rétention est sensible aux cycles d'écriture des cellules qui partagent la même colonne.

Le document [7] sur lequel le préambule de la revendication 1 est basé : divulgue une cellule de mémoire vive à accès aléatoire, dans lequel on fait varier un potentiel appliqué à une électrode <u>de grille</u> de chacun des transistors de charge et de conduction.

Ce document a pour objet la réduction des courants de fuites.

Dans un tel agencement de cellule SRAM, la tension que l'on peut appliquer à la grille des transistors de charge ou de conduction est limitée par la tension de claquage du diélectrique de grille des transistors de charge.

Il se pose le problème de trouver une nouvelle structure de cellule SRAM double-grille, en particulier à 6 transistors, pour laquelle le compromis stabilité en lecture et marge en écriture est amélioré.

## EXPOSÉ DE L'INVENTION

L'invention concerne tout d'abord une cellule de mémoire vive à accès aléatoire (SRAM), comprenant :

- un premier transistor d'accès à double grille et un deuxième transistor d'accès à double grille disposés respectivement entre une première ligne de bit et un premier noeud de stockage, et entre une deuxième ligne de bit et un deuxième noeud de stockage,
- une ligne de mot connectée à une première électrode de grille du premier transistor d'accès et à une première électrode de grille du deuxième transistor d'accès,
- un premier transistor de charge à double grille et un deuxième transistor de charge à double grille,
- un premier transistor de conduction à double grille et un deuxième transistor de conduction à double grille,

un potentiel dit « de référence » étant appliqué à la deuxième grille des transistors de charge ou de conduction

la cellule comportant :

- des moyens pour appliquer un potentiel donné VCELL à au moins une électrode de source ou de drain de chacun des transistors de charge ou de conduction,
- des moyens pour faire varier ledit potentiel donné VCELL.

Le potentiel de référence peut être un potentiel d'alimentation par exemple égal à Vdd ou un potentiel de masse, par exemple égal à Vss.

Une telle cellule est prévue pour adopter différents modes de fonctionnement dont au moins un mode de lecture de données, au moins un mode d'écriture de données, et au moins un mode de rétention de données.

Le potentiel donné VCELL peut adopter différentes valeurs, suivant que la cellule se trouve dans un mode de lecture, d'écriture, ou de rétention.

Les moyens pour faire varier ledit potentiel donné VCELL, peuvent être ainsi prévus pour faire varier ledit potentiel donné VCELL en fonction du mode de fonctionnement dans lequel la cellule est placée.

Selon l'invention, le potentiel donné VCELL appliqué lors des phases d'écritures de la cellule est prévu différent du potentiel de référence (qui peut être par exemple à Vdd, ou à Vss) et de manière à produire un courant de conduction des transistors de charge ou de conduction plus faible que lorsque le potentiel donné VCELL et le potentiel de référence (par exemple égal à Vdd ou Vss) sont égaux.

Selon une première possibilité de mise en oeuvre, les moyens pour appliquer ledit potentiel donné VCELL peuvent être formés d'une ligne de polarisation supplémentaire, spécifique.

Ladite ligne de polarisation supplémentaire peut être connectée à la source des transistors de charge. Dans ce cas, le potentiel donné VCELL n'est avantageusement pas limitée par la tension de claquage du diélectrique de grille des transistors de charge.

Selon cette possibilité, les transistors de charge peuvent comporter une électrode de grille connectée à un potentiel VDD.

Dans ce cas, les moyens pour appliquer ledit potentiel donné et les moyens pour faire varier ledit potentiel donné peuvent être prévus pour, lors d'au moins une phase d'écriture de données dans la cellule : appliquer à la source des transistors de charge, un potentiel VCELL = VDD - $\sigma V$, avec $\sigma V > 0$.

Cela permet notamment de faciliter la décharge du noeud de stockage de niveau logique '1'.

Selon cette possibilité, les moyens pour appliquer ledit potentiel donné et les moyens pour faire varier ledit potentiel donné peuvent être également prévus pour, lors d'au moins une phase de lecture de données de la cellule : appliquer à la source des transistors de charge, un potentiel VCELL = VDD.

Cela permet notamment de faciliter le maintient d'un des noeuds de stockage au niveau logique '1' et de garantir une bonne stabilité en lecture.

Selon cette possibilité, les moyens pour appliquer ledit potentiel donné et les moyens pour faire varier ledit potentiel donné peuvent être également prévus pour, lors d'au moins une phase de rétention de données dans la cellule : appliquer à la source des transistors de charge, un potentiel VDD - $\sigma V$, avec $\sigma V > 0$.

Cela permet notamment de réduire les courants de fuite.

Selon la première possibilité mise en oeuvre, lors de phases d'écriture de données dans ladite cellule, une différence de potentiels $V_{G1} - V_s$ telle que $V_{G1} - V_s = \sigma V$ avec $\sigma V > 0$ volt peut être appliquée entre une première électrode de grille et l'électrode de source, de chacun des transistors de charge.

Selon ladite première possibilité de mise en oeuvre de la cellule, on peut appliquer, lors de phases de lecture de données dans ladite cellule, une différence de potentiels $V_{G1} - V_s$ nulle entre ladite première électrode de grille et ladite électrode de source, de chacun des transistors de charge.

Selon ladite première possibilité de mise en oeuvre de la cellule, on peut appliquer, lors de phases de rétention de données dans ladite cellule, une différence de potentiels $V_{G1} - V_s$ telle que $V_{G1} - V_s = \sigma V$ avec $\sigma V > 0$ volt entre ladite première électrode de grille et ladite électrode de source, de chacun des transistors de charge.

La cellule peut être mise en oeuvre de sorte que $\sigma V = V_{TN}$ avec $V_{TN}$ la tension de seuil d'un transistor double-grille.

Selon une mise en oeuvre possible des moyens pour faire varier ledit potentiel donné, ces moyens peuvent comprendre :

- une ligne de polarisation mise à un potentiel fixe,
- au moins un premier transistor interrupteur à double grille et au moins un deuxième transistor interrupteur à double grille entre la ligne de polarisation donnée et ladite ligne de polarisation mise audit potentiel fixe, le premier transistor interrupteur étant dans une technologie complémentaire de celle du deuxième transistor, les grilles du premier transistor interrupteur et du deuxième transistor interrupteur étant connectées entre elles.

Selon une deuxième possibilité de mise en oeuvre de la cellule, les moyens pour appliquer ledit potentiel donné VCELL peuvent être ladite ligne de mot.

Ladite ligne de mot peut être connectée à la source des transistors de charge.

Les transistors de charge peuvent comporter une électrode de grille connectée à un potentiel VDD.

Dans ce cas, les moyens pour appliquer ledit potentiel donné et les moyens pour faire varier ledit potentiel donné peuvent être également prévus pour : appliquer, lors d'au moins une phase d'écriture de données dans la cellule, un potentiel VCELL, tel que VCELL < VDD.

Les moyens pour appliquer ledit potentiel donné et les moyens pour faire varier ledit potentiel donné peuvent être prévus pour : appliquer à l'électrode de source des transistors de charge, lors d'au moins une phase de rétention de données de la cellule, un potentiel VCELL, tel que VCELL = VDD.

Les moyens pour appliquer ledit potentiel donné et les moyens pour faire varier ledit potentiel donné peuvent être prévus pour : appliquer, lors d'au moins une phase de lecture de données dans la cellule, un potentiel VCELL, tel que VCELL < VDD.

Selon une possibilité, le premier transistor d'accès peut comporter une seconde électrode de grille connectée au deuxième noeud de stockage, le deuxième transistor d'accès comportant une seconde électrode de grille connectée au premier noeud de stockage. Une telle configuration peut permettre d'améliorer la stabilité en lecture.

Selon une variante, la ligne de mot peut être connectée à la source des transistors de conduction.

Dans ce cas, les transistors de conduction peuvent comporter une électrode de grille connectée à un potentiel VSS.

Les moyens pour appliquer ledit potentiel donné et les moyens pour faire varier ledit potentiel donné peuvent être alors prévus pour : appliquer, lors d'au moins une phase d'écriture de données dans la cellule, un potentiel VCELL > VSS.

Les moyens pour appliquer ledit potentiel donné et les moyens pour faire varier ledit potentiel donné peuvent être également prévus pour : appliquer, lors d'au moins une phase de rétention de données de la cellule, un potentiel VCELL = VSS.

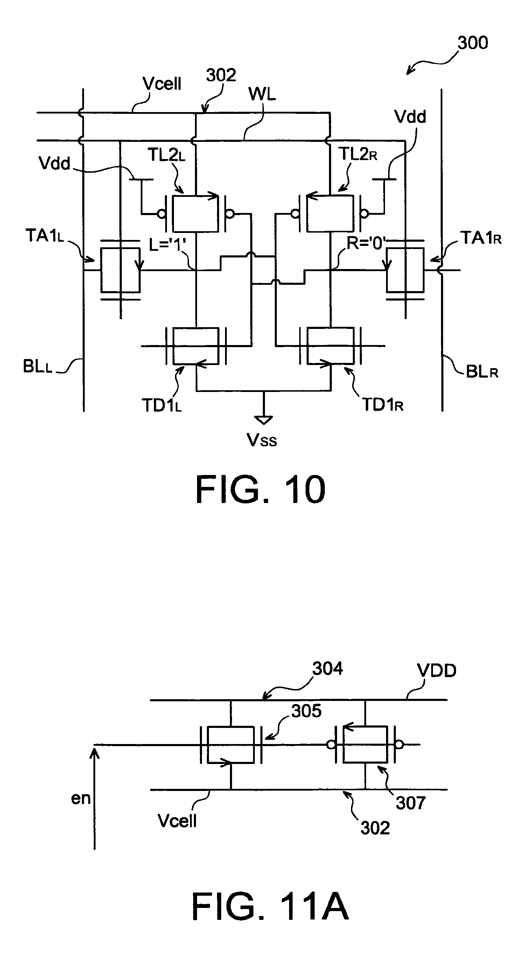

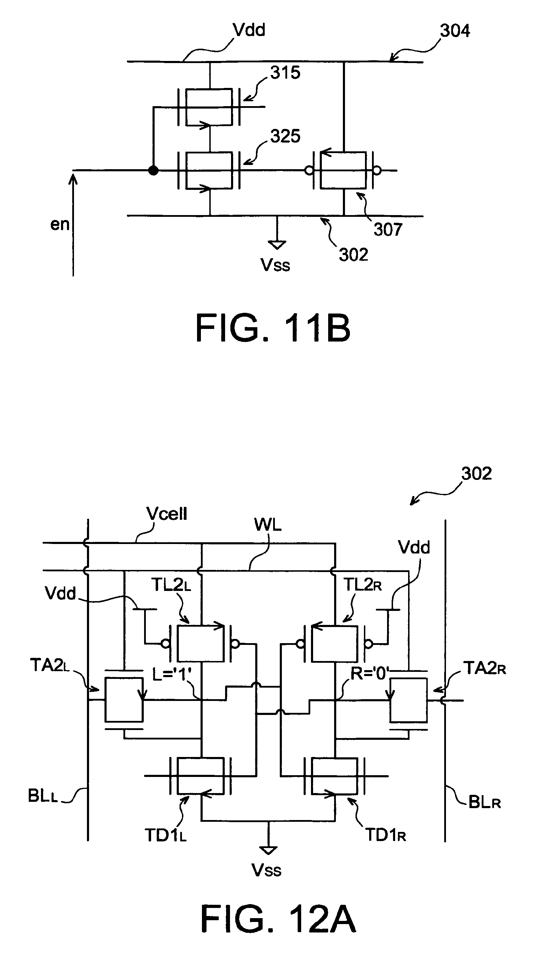

Les moyens pour appliquer ledit potentiel donné et les moyens pour faire varier ledit potentiel donné peuvent être également prévus pour : appliquer, lors d'au moins une phase de lecture de données dans la cellule, un potentiel VCELL > VSS. (moyen équivalent à la figure 11.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1, illustre un exemple de cellule mémoire vive statique 6T suivant l'art antérieur,
- la figure 2, illustre un exemple de cellule mémoire suivant l'art antérieur, dotée de 6 transistors double-grille,
- la figure 3, illustre un exemple de cellule mémoire suivant l'art antérieur, à 7 transistors, dotée d'un transistor supplémentaire d'équilibrage,
- la figure 4, illustre un deuxième exemple de cellule mémoire suivant l'art antérieur, à 6 transistors double-grille,
- la figure 5, illustre un troisième exemple de cellule mémoire suivant l'art antérieur, comportant 6 transistors double-grille,
- la figure 6, illustre un exemple de cellule mémoire suivant l'art antérieur, dotée de 4 transistors double-grille,

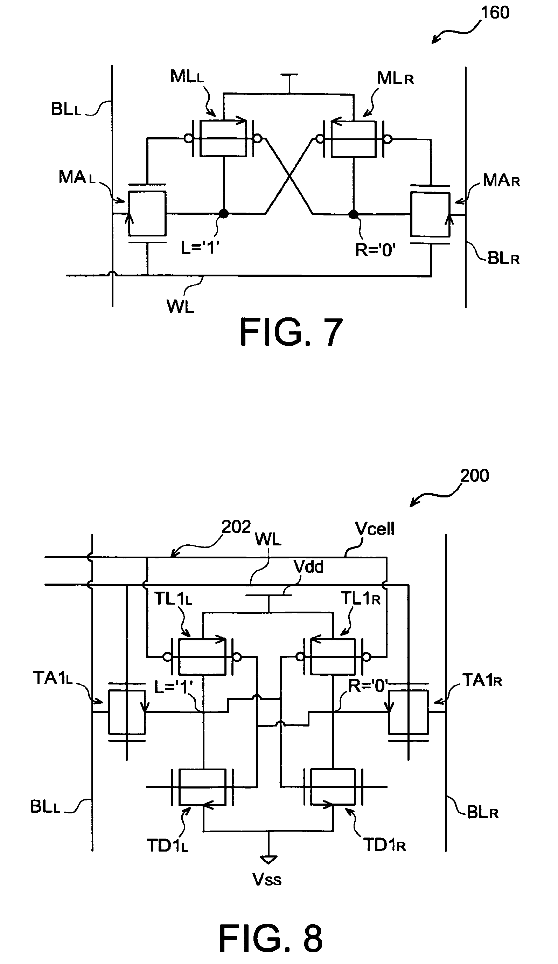

- la figure 7, illustre un autre exemple de cellule mémoire suivant l'art antérieur, comportant 4 transistors double-grille,
- la figure 8, illustre un exemple de cellule mémoire, dotée de 6 transistors double-grille et d'une ligne supplémentaire de polarisation connectée à une électrode de grille des transistors de charge,

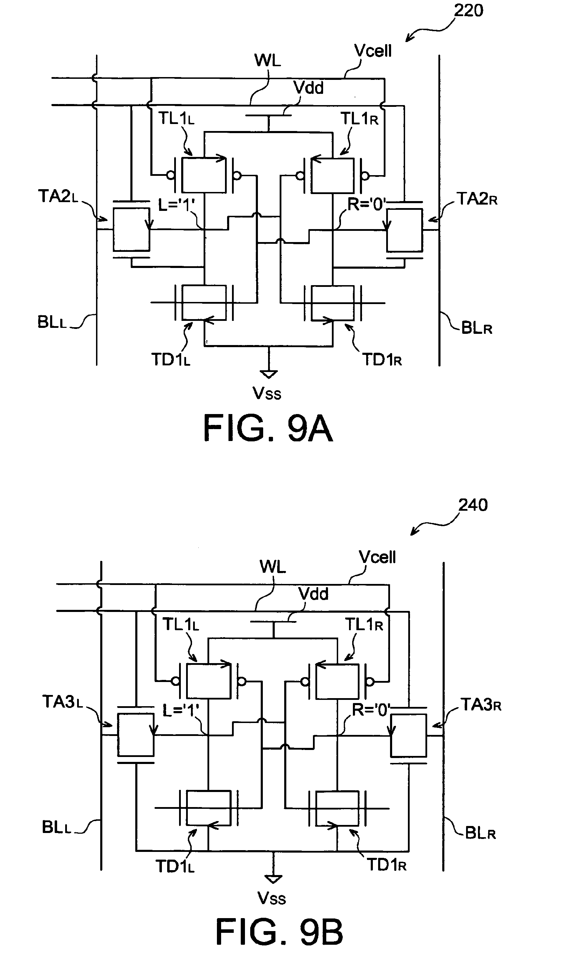

- les figures 9A-9B, illustre un autre exemple de cellule mémoire, dotée de 6 transistors double-grille et d'une ligne supplémentaire de polarisation connectée à une électrode de grille des transistors de charge,
- la figure 10, illustre un exemple de cellule mémoire suivant l'invention, à 6 transistors double-grille et dotée d'une ligne supplémentaire de polarisation connectée à une électrode de source des transistors de charge, pour appliquer une tension VCELL destinée à varier en fonction du mode de fonctionnement dans laquelle est placée la cellule,
- les figures 11A et 11B, illustrent des exemples moyens pour produire ladite tension VCELL et appliquer cette tension à ladite ligne de polarisation supplémentaire de la cellule de la figure 10,
- les figures 12A-12B, illustrent d'autres exemples de cellules mémoire suivant l'invention, à 6 transistors double-grille et dotées de ladite ligne supplémentaire de polarisation connectée à une électrode de source des transistors de charge,

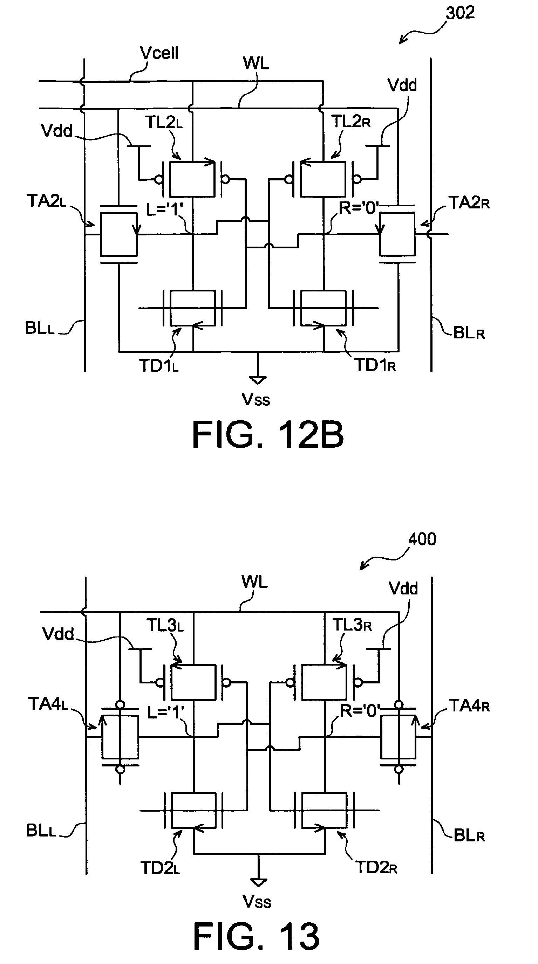

- la figure 13, illustre un autre exemple de cellule mémoire suivant l'invention à 6 transistors double-grille et dont la ligne de mot est prévue pour appliquer un potentiel VCELL à la source des transistors de charge, VCELL étant destiné à varier en fonction du mode de fonctionnement dans laquelle est placée la cellule,

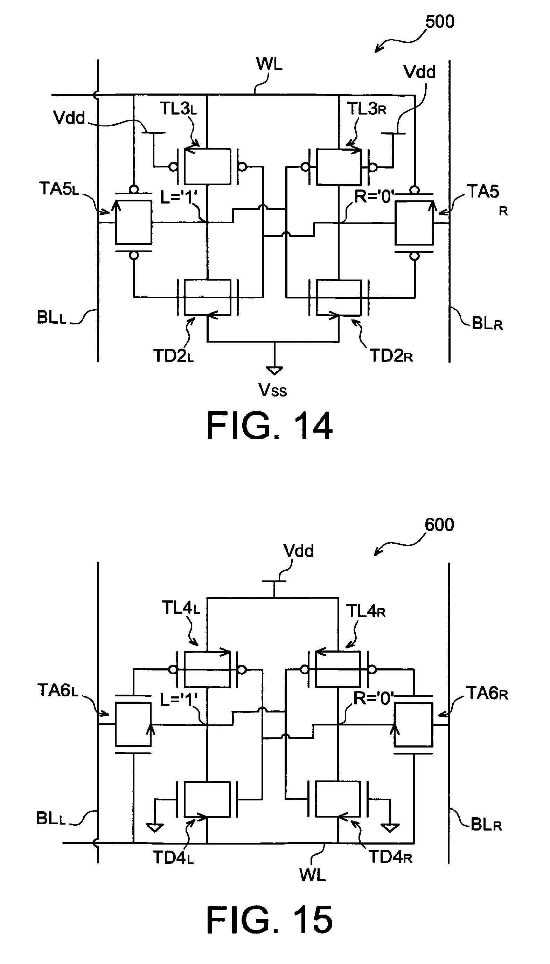

- la figure 14, illustre un autre exemple de cellule mémoire suivant l'invention à 6 transistors double-grille et dont la ligne de mot est prévue pour appliquer un potentiel VCELL à la source des transistors de charge, VCELL étant destiné à varier en fonction du mode de fonctionnement dans laquelle se trouve la cellule,
- la figure 15, illustre un autre exemple de cellule mémoire suivant l'invention à 6 transistors double-grille et dont la ligne de mot est prévue pour appliquer un potentiel VCELL à la source des transistors de conduction, VCELL étant destiné à varier en fonction du mode de fonctionnement dans laquelle se trouve la cellule,

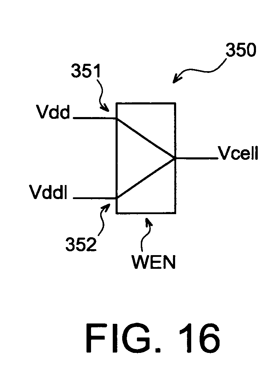

- la figure 16, illustre un autre exemple de moyens prévu pour produire ladite tension VCELL et appliquer cette tension à ladite ligne de polarisation supplémentaire de la cellule de la figure 10.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

Sur la figure 8, un exemple de cellule 200, à 6 transistors (ou « 6T ») d'une mémoire de type SRAM, est donné.

La cellule 200 est formée de transistors réalisés en technologie MOS (MOS pour « Métal Oxide Semi-conductor » ou « semi-conducteur à oxyde de métal ») et à double grille.

La cellule 200 est dotée d'un premier transistor d'accès $TA1_L$ à double grille et d'un deuxième transistor d'accès $TA1_R$ à double grille, qui peuvent être réalisés dans un premier type de technologie MOS donnée par exemple une technologie NMOS.

Le premier transistor d'accès $TA1_L$ est prévu pour, suivant la manière dont il est polarisé, permettre l'accès ou bloquer l'accès à un premier noeud L de stockage destiné à conserver une information logique donnée, par exemple un '1' logique. Le deuxième transistor d'accès $TA1_R$ est prévu pour, suivant la manière dont il est polarisé, permettre l'accès ou bloquer l'accès à un deuxième noeud R de stockage destiné à conserver une information logique complémentaire de ladite information logique donnée, par exemple un '0' logique.

Dans cet exemple, les deux grilles du premier transistor d'accès $TA1_L$ et du deuxième transistor d'accès $TA1_R$ sont reliées à une ligne de mot WL. Autrement dit, les transistors d'accès $TA1_L$ et $TA1_R$ comportent chacun deux électrodes de grille connectées entre elles et à la ligne de mot WL.

La ligne de mot WL est destinée à acheminer un potentiel de polarisation. La ligne de mot WL est destinée à être polarisée différemment, suivant la phase de fonctionnement dans laquelle se trouve la cellule ou le mode de fonctionnement dans lequel se trouve la cellule 200, c'est-à-dire selon que cette cellule 200 se trouve dans une phase de lecture de données ou d'écriture de données, ou dans une phase de rétention de données, c'est-à-dire une phase pendant laquelle des données restent mémorisées dans la cellule 200 sans qu'il y ait d'accès à ces données.

Une électrode drain/source du premier transistor d'accès $TA1_L$ et une électrode drain/source du deuxième transistor d'accès $TA1_R$ sont connectées respectivement à une première ligne de bit $BL_L$ et à une deuxième ligne de bit $BL_R$. Les lignes de bit $BL_L$ et $BL_R$ sont prévues pour transmettre des données à écrire dans la cellule ou des données à lire dans la cellule 200.

La cellule 200 comprend également un premier transistor de charge à double grille $TL1_L$, ainsi qu'un deuxième transistor de charge à double grille $TL1_R$. Les transistors de charge $TL1_L$ et $TL1_R$, peuvent être réalisés dans un deuxième type de technologie MOS donnée, complémentaire dudit premier type, par exemple une technologie de type PMOS. Les sources des transistors de charge $TL1_L$, $TL1_R$ sont connectées entre elles et à un potentiel VDD. Le potentiel VDD peut être par exemple de l'ordre de 1V volt pour des grilles de dimension critique de l'ordre de 45 nanomètres. Le potentiel VDD peut être adapté en fonction de l'application visée pour la cellule 200.

Une électrode de grille du premier transistor de charge à double grille $TL1_L$ est connectée à une ligne de polarisation spécifique 202 prévue pour acheminer un potentiel de polarisation VCELL. Une électrode de grille du deuxième transistor de charge $TL2_R$ est également connectée à ladite ligne de polarisation spécifique 202. Le potentiel de polarisation VCELL est susceptible de varier en fonction du mode de fonctionnement dans laquelle est mise la cellule.

La cellule 200 comprend également un premier transistor de conduction à double grille $TD1_L$, ainsi qu'un deuxième transistor de conduction à double grille $TD1_R$. Les transistors de conduction $TD1_L$ et $TD1_R$, peuvent être réalisés dans un type de technologie MOS complémentaire dudit deuxième type, par exemple une technologie NMOS. Les deux grilles du premier transistor de conduction $TD1_L$ sont connectées ensemble, de même que les deux grilles du deuxième transistor de conduction $TD1_R$ sont également connectées ensemble. Les deux grilles du premier transistor de conduction $TD1_L$ sont également reliées au deuxième noeud de stockage R, tandis que les deux grilles du deuxième transistor de conduction $TD1_R$ sont connectées au premier noeud de stockage L de la cellule 200. Les sources des transistors de conduction $TD1_L$, $TD1_R$ sont connectées entre elles et à un potentiel de référence VSS. Le potentiel de référence VSS peut être par exemple de l'ordre de 0 Volt. Le potentiel de référence peut être adapté suivant l'application visée pour la cellule 200. Le drain du deuxième transistor de conduction $TD1_R$ et le drain du premier transistor de conduction $TD1_L$ sont reliés respectivement au deuxième noeud de stockage R de la cellule 200 et au premier noeud de stockage L de la cellule 200.

Les transistors de charge $TL1_L$, $TL1_R$ et de conduction $TD1_L$, $TD1_R$ forment un bistable pour la cellule 200, et sont prévus pour contrôler et maintenir une information gardée par les noeuds de stockage L, R.

Le premier noeud de stockage L, peut être destiné à conserver une information logique donnée par exemple un '1' logique, tandis que le deuxième noeud de stockage R est destiné à garder une information logique complémentaire de l'information logique, par exemple un '0' logique.

La connexion d'une électrode de grille des transistors de charge $TL1_L$ et $TL1_R$ à la ligne de polarisation supplémentaire 202, et la mise de cette électrode de grille à un potentiel VCELL adapté lors d'une opération d'écriture, permet d'obtenir une marge en écriture améliorée par rapport à une cellule 6T conventionnelle.

Selon un principe de fonctionnement de cette cellule 200, des moyens sont mis en oeuvre pour, lors d'une opération d'écriture, réduire le courant de conduction du premier transistor de charge $TL1_L$ dont le drain est connecté au noeud de stockage destiné à conserver l'information logique '1', par exemple le premier noeud L, afin de faciliter la décharge audit noeud lors d'un cycle d'écriture.

Pour cela, une électrode de grille du premier transistor de charge $TL1_L$ peut être polarisée au potentiel VCELL délivré par la ligne de polarisation supplémentaire 202, avec VCELL = VDD + σV, lors d'une opération d'écriture, avec σV une tension non-nulle.

La tension σV peut être telle que 0 < σV < VGS_claquage_oxyde, avec Vgs_claquage_oxyde une évaluation de la tension de claquage du diélectrique de grille de l'électrode de grille qui est connectée à la ligne de polarisation 202. Cela peut permettre d'augmenter la tension de seuil du premier transistor de charge $TL1_L$ par un effet de polarisation inverse d'une des électrodes de grilles, par exemple de la grille arrière au potentiel $V_{BG}$ par rapport au potentiel de source du transistor $V_S$, $(V_{BGS} = V_{BG}-V_s > 0)$ connecté au potentiel VDD ou par exemple de la grille avant au potentiel $V_{FG}$ par rapport au potentiel $V_s$ de source du transistor, $(V_{FCS} - V_{FG}-V_s > 0)$ qui est connectée au potentiel VDD.

En mode rétention, on peut également appliquer un potentiel VCELL délivré par la ligne de polarisation supplémentaire 202. Le potentiel VCELL appliqué en mode rétention peut être identique à celui appliqué en mode écriture, avec VCELL = VDD + σV ce qui peut permettre de diminuer les courants de fuite de la cellule 200. Le deuxième transistor de charge $TL_R$ qui est connecté au noeud de stockage de niveau logique '0' voit sa tension de seuil augmenter ce qui limite ainsi son courant sous le seuil.

Le potentiel VCELL appliqué par la ligne de polarisation supplémentaire 202 est susceptible d'être modifié ou peut varier, en fonction de la phase de fonctionnement dans laquelle se trouve la cellule 200.

En mode de fonctionnement de lecture, le potentiel VCELL peut être mis par exemple à une valeur VDD, afin de favoriser un maintien du niveau logique '1' as premier noeud L et obtenir une stabilité en lecture SNM équivalente à une cellule standard à 6 transistors.

Des moyens pour faire varier le potentiel VCELL appliqué par la ligne de polarisation 202 supplémentaire sont ainsi mis en oeuvre. Ces moyens sont prévus pour adapter le potentiel VCELL en fonction du mode de fonctionnement dans lequel est placée la cellule. Le potentiel VCELL est destiné à varier selon que cette cellule est dans une phase de lecture, d'écriture, ou de rétention. VCELL = VDD+σV peut être généré avec une pompe de charge par exemple.

Sur la figure 9A, un autre exemple de cellule 220 6T de mémoire SRAM, est donné. Cette cellule 220 est améliorée par rapport à celle (référencée 200) décrite précédemment en liaison avec la figure 8. La cellule 220 diffère de celle décrite précédemment en liaison avec la figure 8, notamment de par l'agencement de ses transistors d'accès référencés $TA2_L$ et $TA2_R$.

Le premier transistor d'accès $TA2_L$ et le deuxième transistor d'accès $TA2_R$ de la cellule 220 comportent, chacun, une première électrode de grille reliée à la ligne de mot WL. Le premier transistor d'accès $TA2_L$ comporte une deuxième électrode de grille reliée au drain du premier transistor de conduction $TD1_L$ et du premier transistor de charge $TL1_L$, tandis que le deuxième transistor d'accès $TA2_R$ comporte également une deuxième électrode de grille reliée au drain du deuxième transistor de conduction $TD1_L$ et du deuxième transistor de charge $TL1_L$. Une telle configuration permet d'obtenir, par rapport à l'exemple de réalisation de la figure 8, une amélioration de la SNM en raison de la réduction du courant de conduction des transistors d'accès.

Sur la figure 9B, un autre exemple de cellule 240 6T de mémoire SRAM est donné. Cette cellule 240 diffère de celle (référencée 200) décrite précédemment en liaison avec la figure 8, notamment de par l'agencement de ses transistors d'accès référencés $TA3_L$ et $TA3_R$. Le premier transistor d'accès $TA3_L$ et le deuxième transistor d'accès $TA3_R$ de la cellule 220 comportent chacun une première électrode de grille reliée à la ligne de mot WL. Le premier transistor d'accès $TA3_L$ comporte également une deuxième électrode de grille reliée à la source du premier transistor de conduction $TD1_L$, tandis que le deuxième transistor d'accès $TA3_R$ comporte également une deuxième électrode de grille reliée à la source du deuxième transistor de conduction $TD1_R$.

Une telle configuration peut permettre d'obtenir une marge en écriture encore améliorée par rapport à la cellule de l'exemple de la figure 9A.

Pour les cellules qui viennent d'être décrites en liaison avec les figures 8, 9A, 9B, la génération du potentiel VCELL en mode écriture peut requérir l'implémentation d'au moins un circuit additionnel de type « pompe de charge » ou communément « level shifter », tels que décrits dans le document de K. Itoh, VLSI Memory Chip Design, Springer-Verlag, pp. 87-88, 2001 and K. Itoh, VLSI Memory Design, Baifukan, Tokyo, 1994.

Dans les exemples qui viennent d'être donnés, la tension VCELL, en particulier en mode écriture, est limitée par la différence de tension entre la grille et le drain du transistor de charge qui est connecté au noeud de stockage de niveau logique '0', cette différence devant être prévue inférieure à la tension de claquage Vgs_claquage_oxyde du diélectrique de grille de la grille connectée à la ligne 202. Vgs_claquage_oxyde peut être par exemple tel que Vgs_claquage_oxyde = Vdd + 300 mV. Dans les exemples de cellules qui viennent d'être donnés, il apparait ainsi que la tension VCELL est limitée par la tension de claquage du diélectrique de grille des transistors de charge.

Des exemples de cellules mémoires SRAM suivant l'invention, vont à présent être donnés. Pour s'affranchir du problème de limitation de la tension VCELL par la tension de claquage du diélectrique de grille des transistors de charge, une solution consiste à appliquer une tension VCELL à une autre électrode que les électrodes de grille des transistors de charge. Une tension VCELL peut être par exemple appliquée, à l'aide d'une ligne de polarisation supplémentaire 302, à la source des transistors de charge de la cellule.

Sur la figure 10, un exemple de cellule 300, suivant l'invention, à 6 transistors (ou « 6T ») et appartenant à une mémoire de type SRAM, est donné.

La cellule 300 diffère de l'exemple des cellules 200, 220 et 240 précédemment décrites en liaison avec la figure 8, notamment de par l'agencement de ses transistors de charge $TL2_L$ et $TL2_R$.

Les transistors de charge $TL2_L$ et $TL2_R$ de la cellule 300 ont chacun une première électrode de grille connectée à un potentiel VDD. Le premier transistor de charge $TL2_L$ de la cellule 300 a une deuxième électrode de grille connectée au deuxième noeud de stockage et à une électrode de grille du premier transistor de conduction $TD1_L$, tandis que le deuxième transistor de charge $TL2_R$ a une deuxième électrode de grille connectée au premier noeud de stockage et à une électrode de grille du deuxième transistor de conduction $TD1_R$.

La source de chacun des transistors de charge $TL2_L$ et $TL2_R$ de la cellule 300 est connectée à une ligne de polarisation 302 spécifique permettant d'acheminer le potentiel VCELL.

Selon un principe de fonctionnement de cette cellule 300, une diminution du courant de conduction des transistors de charge en mode écriture est mise en oeuvre afin de faciliter la décharge du noeud de stockage de niveau logique '1'.

Pour cela, en mode d'écriture, un potentiel VCELL est appliqué sur la ligne de polarisation 302, tel que VCELL = VDD - σV, avec σV une tension telle que σV > 0 volt. La tension σV peut être par exemple telle que : VDD > σV > VRET avec VDD, le potentiel d'alimentation auquel la première électrode de grille des transistors de charge est reliée et VRET la tension minimale de la cellule en rétention. La tension VRET peut être déterminée par exemple de manière statistique à l'aide de simulations Monte-Carlo. La tension VRET peut être déterminée par exemple de telle manière que la moyenne de la stabilité en rétention (RNM) divisée par sa déviation standard est par exemple supérieure à 6. La tension VCELL appliquée en mode écriture, peut être prévue en fonction de la tension minimale de la cellule en rétention VRET, afin de garantir une stabilité suffisante. Le potentiel donné VCELL appliqué lors des phases d'écriture de la cellule est dans cet exemple de réalisation, prévu différent du potentiel d'alimentation Vdd et de manière à produire un courant de conduction des transistors de charge plus faible que lorsque le potentiel donné VCELL et le potentiel d'alimentation Vdd sont égaux, comme ce peut être le cas dans cet exemple lors des phases de lecture.

Selon une possibilité, en mode de rétention d'information, on peut également appliquer un potentiel VCELL sur la ligne de polarisation 302, semblable à celui appliqué en mode d'écriture. Ainsi, on peut également appliquer en mode rétention, un potentiel VCELL, tel que VCELL = VDD - σV, avec σV une tension telle que σV > 0 volt afin de réduire les courants de fuite de la cellule, σV pouvant être par exemple telle que : VDD > σV > VRET.

Par rapport à la consommation statique des exemples de cellules décrites en liaison avec les figures 8, 9A, et 9B, celle de la cellule 300 est davantage réduite. Un tel agencement de la ligne de polarisation 302 par rapport aux sources de transistors de charge permet une réduction des courants de fuite dans les deux inverseurs de la cellule. Une diminution du courant sous le seuil du deuxième transistor de charge $TL2_R$ connecté au deuxième noeud de stockage R de niveau logique '0' et une réduction des courants de fuite du premier transistor de conduction $TD2_L$ connecté au premier noeud de stockage L de niveau logique '1' peuvent être mises en oeuvre.

En mode lecture, la tension VCELL peut être différente de celle appliquée lors des opérations de rétention et d'écriture, telle que VCELL = VDD peut être appliquée. Cela peut permettre de favoriser un maintien du niveau logique '1'.

Sur la figure 11A, un exemple de réalisation de moyens pour produire la tension VCELL et appliquer cette tension à la ligne de polarisation supplémentaire en fonction du mode dans lequel est placée la cellule 300, est donné.

Les moyens pour appliquer la tension VCELL peuvent recevoir en entrée une tension d'entrée En, également destinée à adopter plusieurs états ou valeurs, en fonction du mode dans lequel la cellule 300 est placée. Le signal En peut être généré par un bloc de contrôle du circuit mémoire.

Les moyens pour appliquer la tension VCELL peuvent être formés de deux transistors 305, 307 de type complémentaire au transistor 305 à double grille, situés entre une ligne de polarisation 304 qui peut être mise au potentiel VDD, et la ligne de polarisation supplémentaire 302. Un premier transistor double-grille 305 a un drain connecté à la ligne de polarisation 304 et une source connectée à la ligne de polarisation supplémentaire 302. Un deuxième transistor double-grille 307 a une source connectée à la ligne de polarisation 304 et un drain connecté à la ligne de polarisation supplémentaire 302. Les deux électrodes de grille du transistor 305, sont connectées entre elles et à celles du transistor 307. Le signal d'entrée En est appliqué aux doubles grilles de transistors 305, 307.

Pour En=VSS, on a VCELL=VDD car le transistor 307 est activé, le transistor 305 étant, quant à lui, bloqué.

Pour En=VDD, on a VCELL=VDD-VTN (VTN=tension de seuil du transistor NMOS) car le transistor PMOS est bloqué et le transistor NMOS est activé.

En mode lecture, la tension d'entrée En, peut adopter un premier état ou une première valeur, et par exemple telle que En = 0 V, ce qui met la ligne de polarisation supplémentaire 302 au potentiel VDD, de sorte que VCELL = VDD.

En mode écriture, le signal En, peut adopter un deuxième état ou une deuxième valeur, et être par exemple tel que En = VDD, ce qui met la ligne de polarisation supplémentaire 302 à VCELL = VDD - VTN, avec VTN la tension de seuil du transistor 305. Dans ce cas de figure, on a σV = VTN.

Il est également possible de faire en sorte que σV = k*VTN avec k > 1, par exemple en prévoyant plusieurs transistors NMOS empilés à la place du transistor 305.

Sur la figure 11B, un exemple de réalisation avec k = 2 transistors 315 et 325 empilés est donné. En mode lecture, la tension d'entrée En, peut adopter un premier état ou une première valeur, et par exemple telle que En = 0 V, ce qui met la ligne de polarisation supplémentaire 302 au potentiel VDD, de sorte que VCELL = VDD.

En mode écriture, le signal En, peut adopter un deuxième état ou une deuxième valeur, et être par exemple tel que En = VDD, ce qui met la ligne de polarisation supplémentaire 302 à VCELL = VDD - 2*VTN, avec VTN la tension de seuil du transistor 305. Dans ce cas de figure, on a σV = 2*VTN.

Dans cet exemple de réalisation, la tension VCELL appliquée à la source de transistors de charge est avantageusement inférieure au potentiel VDD. En terme de consommation cette cellule est ainsi meilleure que celle de l'exemple de la figure 8.

Cela peut également permettre de s'affranchir de l'utilisation de circuits de type level shifter ou pompe de charge et de permettre ainsi un gain de place.

Les moyens pour appliquer la tension VCELL ne sont pas limités aux exemples de réalisation qui viennent d'être donnés.

Sur la figure 16, un autre exemple de moyens pour appliquer le potentiel VCELL est donné. Ces moyens comportent des moyens de commutation 350 recevant sur une première entrée 351, un premier potentiel d'alimentation VDD du circuit mémoire, par exemple égal à 1,2 volts, et sur une deuxième entrée 352, un deuxième potentiel d'alimentation VDDL du circuit mémoire et qui est inférieur à VDD, par exemple égal à 0,9 volts.

Selon l'état d'un signal WEN, c'est la première entrée 352 ou la deuxième entrée 354 qui est émise en sortie des moyens de commutation 350.

En mode lecture, le signal WEN, peut adopter un premier état, la sortie des moyens de commutation 350 étant alors telle que la ligne de polarisation supplémentaire 302, est au potentiel VDD, de sorte que VCELL = VDD.

En mode écriture, le signal WEN, peut adopter un deuxième état, la sortie des moyens de commutation 350 étant alors telle que la ligne de polarisation supplémentaire 302, est au potentiel VDDL, de sorte que VCELL = VDD - σV = VDDL .

Ainsi, le potentiel VCELL appliqué lors des phases d'écritures de la cellule est dans cet exemple de réalisation, prévu différent du potentiel de référence Vdd et de manière à produire un courant de conduction des transistors de charge ou de conduction plus faible que lorsque le potentiel donné VCELL et le potentiel de référence Vdd sont égaux.

Sur la figure 12A, un autre exemple de cellule 320, est donné. La cellule 320 diffère de la cellule décrite précédemment en liaison avec la figure 10, notamment de par l'agencement de ses transistors d'accès référencés $TA2_L$ et $TA2_R$.

Le premier transistor d'accès $TA2_L$ et le deuxième transistor d'accès $TA2_R$ de la cellule 220 comportent chacun une première électrode de grille reliée à la ligne de mot WL. Le premier transistor d'accès $TA2_L$ comporte également une deuxième électrode de grille reliée au drain du premier transistor de conduction $TD1_L$ et du premier transistor de charge $TL2_L$. Le deuxième transistor d'accès $TA2_R$ comporte également une deuxième électrode de grille reliée au drain du deuxième transistor de conduction $TD1_R$ et du deuxième transistor de charge $TL2_R$.

Sur la figure 12B, un autre exemple de cellule 340, est donné. La cellule 340 diffère de la cellule décrite précédemment en liaison avec la figure 10, notamment de par l'agencement de ses transistors d'accès $TA3_L$ et $TA3_R$. Le premier transistor d'accès $TA3_L$ comporte une électrode de grille reliée à la source du premier transistor de conduction $TD1_L$, tandis que le deuxième transistor d'accès $TA3_R$ comporte une électrode de grille reliée à la source du deuxième transistor de conduction $TD1_R$.

Selon une autre possibilité de réalisation, on peut modifier la polarisation des transistors de charge de la cellule en leur appliquant un potentiel VCELL, prévu pour varier en fonction du mode de fonctionnement dans laquelle se trouve cette cellule, i.e suivant qu'elle se trouve dans un mode de rétention, de lecture ou d'écriture, tout en s'affranchissant d'une ligne de polarisation supplémentaire. Par rapport aux cellules conventionnelles, on peut ainsi obtenir une marge en écriture améliorée tout en conservant un encombrement de la cellule identique ou semblable.

Pour cela, les transistors de charge peuvent comporter chacun au moins une électrode connectée à la ligne de mot WL. Dans cette autre possibilité de réalisation, la tension VCELL est appliquée aux transistors de charge à l'aide de la ligne de mot WL en fonction du mode dans lequel est placée la cellule 300.

Sur la figure 13, un exemple de cellule 400 selon cette autre possibilité de réalisation, est donné.

La cellule 400 diffère de celle (référencée 300) précédemment décrite en liaison avec la figure 10, notamment de par ses transistors d'accès $TA4_L$ et $TA4_R$, qui sont réalisés dans une technologie complémentaire de celle dans laquelle sont réalisés les transistors de conduction de la cellule 300. Les transistors d'accès $TA4_L$ et $TA4_R$ de la cellule 400 peuvent être réalisés en technologie PMOS. Les transistors d'accès $TA4_L$, $TA4_R$ de la cellule 400 ont leurs électrodes de grille connectées à la ligne de mot WL.

La cellule 400 diffère de celle (référencée 300) précédemment décrite en liaison avec la figure 10, également de par l'agencement de ses transistors de charge $TL3_L$, $TL3_R$. Les transistors de charge $TL3_L$, $TL3_R$ de la cellule 400 ont leur source connectée à la ligne de mot WL.

La polarisation de la ligne de mot WL en mode rétention peut être telle que les transistors d'accès $TA3_L$ et $TA3_R$ sont mis dans un état bloqué. En mode rétention, la ligne de mot WL peut être maintenue au potentiel VCELL = VDD. La source des transistors de charges TL3$_L$, TL3$_R$ est ainsi mise au potentiel VDD.

En modes de lecture et d'écriture, la ligne de mot WL peut être polarisée à un potentiel VCELL inférieur à VDD, par exemple à un potentiel VSS de l'ordre de 0V.

En modes de lecture et d'écriture, les transistors d'accès sont activés et le premier transistor de charge TL3$_L$ connecté au premier noeud de stockage L de niveau logique '1' n'est plus conducteur ou devient moins conducteur. Il en résulte une amélioration des opérations d'écriture.

Le potentiel donné VCELL appliqué lors des phases d'écritures de la cellule est dans cet exemple de réalisation, prévu inférieur au potentiel VDD et de manière à produire un courant de conduction des transistors de charge plus faible que lorsque le potentiel donné VCELL et le potentiel de référence Vdd sont égaux.

Sur la figure 14, un autre exemple de cellule 500, à 6 transistors (ou « 6T ») d'une cellule mémoire de type SRAM, est donné. La cellule 500 diffère de la cellule (référencée 400) précédemment décrite en liaison avec la figure 13, de par l'agencement de ses transistors d'accès TA5$_L$ et TA5$_R$.

Une première électrode de grille du premier transistor d'accès TA5$_L$ à double-grille est connectée à la ligne de mot WL, tandis qu'une première électrode de grille du deuxième transistor d'accès TA5$_R$ à double-grille est également connectée à la ligne de mot WL.

Le premier transistor d'accès TA4$_L$, qui permet d'autoriser l'accès ou de bloquer l'accès au premier noeud L, comporte une deuxième électrode de grille connectée au deuxième noeud R. Le deuxième transistor d'accès TA5$_R$, qui permet d'autoriser l'accès ou de bloquer l'accès au deuxième noeud R, comporte une deuxième électrode de grille connectée au premier noeud L.

La deuxième électrode de grille du premier transistor d'accès TA5$_L$ de la cellule 500 peut être connectée aux électrodes de grille du premier transistor de conduction TD2$_L$, tandis que la deuxième électrode de grille du deuxième transistor d'accès TA5$_R$ de la cellule 500 peut être également connectée aux électrodes de grille du deuxième transistor de conduction TD2$_R$.

Une telle configuration peut permettre d'obtenir une stabilité en lecture améliorée. La mise en oeuvre d'une telle rétroaction permet de limiter le courant de conduction du transistor d'accès connecté au deuxième noeud de stockage R de niveau logique '0' .

Afin de limiter les courants de fuite, les transistors d'accès TA5$_L$ et TA5$_R$ peuvent être à double grille asymétrique, par exemple en prévoyant des couches diélectriques d'épaisseurs différentes pour la double grille.

Sur la figure 15, un autre exemple de cellule 600, à 6 transistors (ou « 6T ») d'une mémoire de type SRAM, est représenté.

La cellule 600 est dotée d'un premier transistor d'accès TA6$_L$ à double grille et d'un deuxième transistor d'accès TA6$_R$ à double grille, qui peuvent être réalisés dans un premier type de technologie MOS donnée par exemple de type NMOS. Le premier transistor d'accès TA6$_L$ est situé entre une première ligne de bit BL$_L$ et un premier noeud de stockage L, tandis que le deuxième transistor d'accès TA5$_R$ est situé entre une deuxième ligne de bit BL$_R$ et un deuxième noeud de stockage R.

Dans cet exemple, le premier transistor d'accès TA6$_L$ et le deuxième transistor d'accès TA6$_R$ comportent une électrode de grille reliée à une ligne de mot WL. Le premier transistor d'accès TA6$_L$ comporte une autre électrode de grille connectée à la grille d'un premier transistor de charge TL4$_L$. Le deuxième transistor d'accès TA6$_R$ comporte également une autre électrode de grille connectée à la grille d'un deuxième transistor de charge TL4$_R$.

Les transistors de charge TL4$_L$ et TL4$_R$, peuvent être réalisés dans un type de technologie MOS donnée, complémentaire de celle dans laquelle sont réalisés les transistors d'accès, par exemple une technologie de type PMOS. Les transistors de charge TL4$_L$ et TL4$_R$ ont une source reliée à un potentiel d'alimentation VDD. Les électrodes de grilles du premier transistor de charge TL4$_L$ sont connectées entre elles, tandis que les électrodes de grille du deuxième transistor de charge TL4$_R$ sont également connectées entre elles.

Le premier transistor de charge TL4$_L$ comporte un drain connecté au drain d'un premier transistor de conduction TD4$_L$. Le deuxième transistor de charge TL4$_R$ comporte un drain connecté au drain d'un deuxième transistor de conduction TD4$_R$. Le premier transistor de conduction TD4$_L$ comporte une source connectée à la ligne de mot WL, tandis que le deuxième transistor de conduction TD4$_R$ comporte une source également connectée à la ligne de mot WL. Ainsi, dans cet exemple, ce sont les transistors de conduction TD4$_L$ et TD4$_R$ dont on fait varier l'état de polarisation, par l'intermédiaire d'un potentiel VCELL appliqué sur la ligne de mot WL, suivant le mode de fonctionnement dans lequel est placée la cellule 600.

Les transistors de conduction TD4$_L$, TD4$_R$ comportent chacun une électrode de grille reliée à la masse ou à un potentiel de référence VSS.

Le potentiel donné VCELL appliqué lors des phases d'écritures de la cellule 600 est prévu différent du potentiel de référence Vss et de manière à produire un courant de conduction des transistors de conduction plus faible lors des phases d'écritures, en particulier plus faible que lorsque le potentiel donné VCELL et le potentiel de référence Vss sont égaux.

Une autre électrode de grille du premier transistor de conduction TD4$_L$ est connectée aux électrodes de grille du premier transistor de charge TL4$_L$, tandis qu'une électrode de grille du deuxième transistor de conduction TD4$_R$ est connectée aux électrodes de grille du deuxième transistor de charge TL4$_R$.

En mode de rétention la ligne de mot WL peut être mise à 0 V, afin de rendre les transistors d'accès bloqués.

En mode de lecture, la ligne de mot WL peut être mise à un potentiel supérieur à 0 V, par exemple au potentiel VDD.

En mode d'écriture, la ligne de mot WL peut être mise à un potentiel supérieur à 0 V, par exemple au potentiel VDD.

Pour limiter les courants de fuite, des transistors d'accès à double-grille asymétrique peuvent être mis en oeuvre. Des transistors d'accès à double-grille asymétrique peuvent être réalisés à l'aide d'un diélectrique de grille plus épais pour une électrode de grille que le diélectrique de grille de l'autre électrode de grille.

Une comparaison de caractéristiques électriques d'exemple de cellules de type 6T mises en oeuvre suivant l'invention, par rapport à celles d'une cellule suivant l'art antérieur, dite « 6T standard », va à présent être donnée en liaison avec le tableau ci-dessous.

La cellule 6T conventionnelle a été dimensionnée de manière à avoir une surface occupée faible et une stabilité en lecture supérieure ou égale à 200 mV.

Pour cette comparaison, les transistors des autres cellules ont été dimensionnées avec les mêmes longueurs et largeurs de grille afin d'évaluer précisément l'apport des architectures proposées.

Le tableau 1 présente le dimensionnement choisi des transistors de charge TL, des transistors d'accès TA et des transistors de conduction TD, la longueur et la largeur de grille minimum étant respectivement de 50 nm et de 100 nm.

Tableau 1 : Dimensionnement des points mémoires

| (W/L)$_{TL}$ (nm) | (w/L)$_{TA}$ (nm) | (W/L)$_{TD}$ (nm) |
|---|---|---|
| 100/50 | 100/70 | 300/50 |

Le tableau 2 ci-dessous donne des résultats de simulation obtenus avec le logiciel ELDO et un modèle implémenté en VerilogA et tel que présenté dans M. Reyboz et al., "Explicit Threshold Voltage Based Compact Model Of Independent Double Gate (IDG) MOSFET Including Short Channel Effects", CEA, Grenoble, d'une cellule 6T conventionnelle, et de cellules telles que les cellules 200, 300, 400, 500 décrites précédemment. Les cellules ont un même dimensionnement.

Tableau 2 : Caractéristiques électriques

| Critères | 6T conventionnelle | Cellule 200 | Cellule 300 | Cellule 400 | Cellule 500 |
|---|---|---|---|---|---|
| Stabilité (SNM) en lecture (mV) | 203 | 162 | 162 | 264 | 346 |
| Rétention (mV) | 349 | 320 | 212 | 329 | 377 |
| I$_{LEAK}$ (nA) | 1,89 | 1,63 | 0,83 | 1,86 | 1,87 |
| Marge en écriture (mV) | 847 | 647 | 573 | 579 | 639 |

La cellule 200 a une marge en écriture améliorée de l'ordre de 24 % par rapport à la cellule 6T conventionnelle, ainsi qu'une consommation statique améliorée d'environ 14 %. La stabilité d'une telle cellule 200 peut être améliorée en optimisant le dimensionnement de ses transistors, ou en mettant en oeuvre une rétroaction telle que dans les cellules décrites en liaison avec les figures 9A et 9B.

La cellule 300 comporte une marge en écriture améliorée de l'ordre de 32 %, avec une réduction de la consommation statique de l'ordre de 56 % (tension d'alimentation réduite de 300 mV) par rapport à une cellule 6T conventionnelle. La stabilité d'une telle cellule 300 peut être améliorée en optimisant le dimensionnement de ses transistors, ou en mettant en oeuvre une rétroaction telle que dans les cellules décrites en liaison avec les figures 12A et 12B.

La cellule 400 a une marge en écriture et une stabilité en lecture améliorées de plus de 30 % pour une consommation équivalente, par rapport à une cellule 6T conventionnelle.

En comparaison avec une cellule 6T conventionnelle, la cellule 500 a, quant à elle, une marge en écriture améliorée de l'ordre de 25 % et est caractérisée par une nette augmentation de sa stabilité en lecture, avec un gain de 70 %. La stabilité en rétention a également été améliorée de 8%.

Globalement, les cellules précédemment décrites permettent d'améliorer le compromis marge en écriture et stabilité en lecture.

**DOCUMENTS CITES** :

[1] : Z. Guo, S. Balasubramanian, R. Ziatanovici, T-J. King and B. Nikoli'c, "FinFET-Based SRAM Design", UC Berkeley, ISLPED, San Diego, California, USA, 2005.

[2] : J.-S. Wang et al. "Current-mode Write-circuit of static RAM", US005991192A, 1999.

[3] : M. Yamaoka, K. Osada, R. Tsuchiya, M. Horiuchi, S. Kirnura and T. Kawahara, "Low power SRAM menu for SOC application using Yin- Yang-feedback memory cell technology", Syrnp. VLSI Circuits Dig. 18, pp. 288 -291,2004.

[4] : B. Giraud, A. Vladimirescu and A. Amara, « A Comparative Study of 6T and 4T SRAM Cells in Double Gate CMOS with Statistical Variation », ISCAS May 2007, New Orleans, USA.

[5] : E. Seevinck Sr. et al., "Static-noise margin analysis of MOS SRAM ceils", IEEE JSSCC, vol. 22, PP. 748 - 754, 1987.

[6] : B. Giraud, A. Vladirnirescu and A. Arnara, « Indepth Analysis of 4T SRAM Cells in Double-Gate CMOS », ICICDT May 2007, Austin, USA.

[7] : US 2007/0139072 AI

**Revendications**

1. Cellule de mémoire vive à accès aléatoire, comprenant :

   - un premier transistor d'accès (TA1$_L$, TA2$_L$, TA3$_L$, TA4$_L$, TA5$_L$, TA6$_L$) à double grille et un deuxième transistor d'accès (TA1p, TA2$_P$, TA3$_R$, TA4$_R$, TA5$_P$, TA6$_R$) à double grille disposés respectivement entre une première ligne de bit (BL$_L$) et un premier noeud de stockage (L), et entre une deuxième ligne de bit (BL$_R$) et un deuxième noeud de stockage (R),
   - une ligne de mot (WL) connectée à une première électrode de grille du premier transistor d'accès et à une première électrode de grille du deuxième transistor d'accès,
   - un premier transistor de charge (TL1$_L$, TL2$_L$, TL3$_L$, TL4$_L$) à double grille et un deuxième transistor de charge (TL1$_R$, TL2$_R$, TL3$_R$, TL4$_R$) à double grille,
   - un premier transistor de conduction (TD1$_L$, TD2$_L$, TD3$_L$) à double grille et un deuxième transistor de conduction (TD1$_R$, TD2$_R$, TD3$_R$) à double grille,

   un potentiel de référence (Vdd, Vss) est appliqué à la deuxième grille des transistors de charge (TL1$_R$, TL2$_R$, TL3$_R$, TL4$_R$) ou de conduction (TD1$_R$, TD2$_R$, TD3$_R$), **caractérisé par** la cellule comportant en outre : des moyens pour appliquer un potentiel donné variable (VCELL) à au moins une électrode de source ou de drain de chacun des transistors de charge ou de conduction, et par
   le potentiel donné VCELL appliqué lors des phases d'écritures de la cellule étant prévu différent du potentiel de référence (Vdd, Vss) et de manière à produire un courant de conduction des transistors de charge ou de conduction plus faible lors des phases d'écritures que lorsque le potentiel donné VCELL et le potentiel de référence (Vdd, Vss) sont égaux.

2. Cellule de mémoire vive à accès aléatoire selon la revendication 1, dans laquelle les moyens pour appliquer ledit potentiel donné (VCELL) sont formés d'une ligne de polarisation supplémentaire (202, 302).

3. Cellule de mémoire vive à accès aléatoire selon l'une des revendications 1 ou 2, ladite ligne de polarisation supplémentaire (202, 302) étant connectée à la source des transistors de charge (TL2$_L$, TL2$_R$) .

4. Cellule de mémoire vive à accès aléatoire selon la revendication 3, comprenant en outre:

   - des moyens pour appliquer, lors de phases d'écriture de données dans ladite cellule, une différence de potentiels $V_{G1} - V_s$ telle que $V_{G1}$ $V_s = \sigma V$ avec $\sigma V > 0$ volt entre une première électrode de grille et l'électrode de source, de chacun des transistors de charge (TL1$_L$, TL1$_R$, TL2$_L$, TL2$_R$),

- et/ou des moyens pour appliquer, lors de phases de lecture de données dans ladite cellule, une différence de potentiels V$_{G1}$ - V$_s$ nulle entre ladite première électrode de grille et ladite électrode de source, de chacun des transistors de charge (TL1$_L$, TL1$_R$, TL2$_L$, TL2$_R$),

- et/ou des moyens pour appliquer, lors de phases de rétention de données dans ladite cellule, une différence de potentiels V$_{G1}$ - V$_s$ telle que V$_{G1}$ - V$_s$ = σV avec σV > 0 volt entre ladite première électrode de grille et ladite électrode de source, de chacun des transistors de charge.

5. Cellule de mémoire vive à accès aléatoire selon la revendication 3, dans lequel les transistors de charge (TL1$_L$, TL1$_R$) comportent une électrode de grille connectée à un potentiel VDD, les moyens pour appliquer ledit potentiel donné étant prévus pour :

- appliquer à l'électrode de source des transistors de charge, lors d'au moins une phase d'écriture de données dans la cellule, un potentiel VCELL = VDD - σV, avec σV > 0,
- et/ou appliquer à l'électrode de source des transistors de charge, lors d'au moins une phase de lecture de données de la cellule, un potentiel VCELL = VDD,
- et/ou appliquer à l'électrode de source des transistors de charge, pendant au moins une phase de rétention de données dans la cellule, un potentiel VDD - σV, avec σV > 0.

6. Cellule de mémoire vive à accès aléatoire selon la revendication 5, dans lequel σV = V$_{TN}$ avec V$_{TN}$ la tension de seuil d'un transistor double-grille.

7. Cellule de mémoire vive à accès aléatoire selon l'une des revendications 1 à 6, comprenant en outre : des moyens pour faire varier ledit potentiel donné VCELL.

8. Cellule de mémoire vive à accès aléatoire selon la revendication 7, les moyens pour faire varier ledit potentiel donné comprenant :

- une ligne de polarisation (304) mise à un potentiel fixe,
- au moins un premier transistor interrupteur (305) à double grille et au moins un deuxième transistor interrupteur (307) à double grille entre la ligne de polarisation donnée (302) et ladite ligne de polarisation mise audit potentiel fixe, le premier transistor interrupteur étant dans une technologie complémentaire de celle du deuxième transistor, les grilles du premier transistor interrupteur et du deuxième transistor interrupteur étant connectées entre elles.

9. Cellule de mémoire vive à accès aléatoire selon la revendication 1, dans laquelle les moyens pour appliquer ledit potentiel donné VCELL sont ladite ligne de mot (WL).

10. Cellule de mémoire vive à accès aléatoire selon la revendication 13, ladite ligne de mot (WL) étant connectée à la source des transistors de charge (TL$_L$, TL$_R$) .

11. Cellule de mémoire vive à accès aléatoire selon la revendication 9 ou 10, dans lequel les transistors de charge comportent une électrode de grille connectée à un potentiel VDD, les moyens pour appliquer ledit potentiel donné étant prévus pour :

- appliquer à l'électrode de source des transistors de charge, lors d'au moins une phase d'écriture de données dans la cellule, un potentiel VCELL < VDD,
- et/ou appliquer à l'électrode de source des transistors de charge, lors d'au moins une phase de lecture de données dans la cellule, un potentiel VCELL < VDD,
- et/ou appliquer à l'électrode de source des transistors de charge, lors d'au moins une phase de rétention de données de la cellule, un potentiel VCELL = VDD,

12. Cellule de mémoire vive à accès aléatoire selon l'une des revendications 9 à 11, le premier transistor d'accès comportant une seconde électrode de grille connectée au deuxième noeud de stockage, le deuxième transistor d'accès comportant une seconde électrode de grille connectée au premier noeud de stockage.

13. Cellule de mémoire vive à accès aléatoire selon la revendication 9, ladite ligne de mot (WL) étant connectée à la source des transistors de conduction (TD$_L$, TD$_R$).

**14.** Cellule de mémoire vive à accès aléatoire selon la revendication 13, dans lequel les transistors de conduction comportent une électrode de grille connectée à un potentiel VSS, les moyens pour appliquer ledit potentiel donné étant prévus pour :

- appliquer à l'électrode de source des transistors de conduction, lors d'au moins une phase d'écriture de données dans la cellule, un potentiel VCELL > VSS,
- et/ou appliquer à l'électrode de source des transistors de conduction, lors d'au moins une phase de rétention de données de la cellule, un potentiel VCELL = VSS,
- et /ou appliquer à l'électrode de source des transistors de conduction, lors d'au moins une phase de lecture de données dans la cellule, un potentiel VCELL > VSS.

**Claims**

**1.** Random access memory cell, comprising:

- a first double gate access transistor ($TA1_L$, $TA2_L$, $TA3_L$, $TA4_L$, $TA5_L$, $TA6_L$) and a second double gate access transistor ($TAL_R$, $TA2_R$, $TA3_R$, $TA4_R$, $TA5_R$, $TA6_R$) respectively arranged between a first bit line ($BL_L$) and a first storage node (L) , and between a second bit line ($BL_R$) and a second storage node (R),
- a word line (WL) connected to a first gate electrode of the first access transistor and to a first gate electrode of the second access transistor,
- a first double gate load transistor ($TL1_L$, $TL2_L$, $TL3_L$, $TL4_L$) and a second double gate load transistor ($TL1_R$, $TL2_R$, $TL3_R$, $TL4_R$),
- a first double gate driver transistor ($TD1_L$, $TD2_L$, $TD3_L$) and a second double gate driver transistor ($TD1_R$, $TD2_R$, $TD3_R$),

a reference potential (Vdd, Vss) is applied to the second gate of the load ($TL1_R$, $TL2_R$, $TL3_R$, $TL4_R$) or driver ($TD1_R$, $TD2_R$, $TD3_R$) transistors,
the cell further comprising: means to apply a given variable potential (VCELL) to at least one source or drain electrode of each of the load or driver transistors,
the given potential VCELL applied during write phases of the cell being designed to be different from the reference potential (Vdd, Vss) and so as to produce a lower drive current of the load or driver transistors during write phases than when the given potential VCELL and the reference potential (Vdd, Vss) are equal.

**2.** Random access memory cell according to claim 1, wherein the means to apply said given potential (VCELL) are formed of an additional polarization line (202, 302).

**3.** Random access memory cell according to either of claims 1 or 2, said additional polarization line (202, 302) being connected to the source of the load transistors ($TL2_L$, $TL2_R$).

**4.** Random access memory cell according to claim 3, further comprising:

- means which, during data write phases in said cell, apply a difference in potential $V_{G1} - V_s$ such that $V_{G1} - V_s$ = σV in which σV > 0 volt between a first gate electrode and the source electrode of each of the load transistors ($TL1_L$, $TL1_R$, $TL2_L$, $TL2_R$),
- and/or means which, during data read phases in said cell, apply a zero potential difference $V_{G1} - V_s$ between said first gate electrode and said source electrode of each of the load transistors ($TL1_L$, $TL1_R$, $TL2_L$, $TL2_R$).
- and/or means which, during data retention phases in said cell, apply a potential difference $V_{G1} - V_s$ such that $V_{G1} - V_s$ = σV in which σV > 0 volt between said first gate electrode and said source electrode of each of the load transistors.

**5.** Random access memory cell according to claim 3, wherein the load transistors ($TL1_L$, $TL1_R$) comprise a gate electrode connected to a potential VDD,

- the means to apply said given potential being designed to: apply to the source electrode of the load transistors, during at least one data write phase in the cell, a potential VCELL = VDD - σV in which σV > 0.
- the means to apply said given potential being designed to: apply to the source electrode of the load transistors, during at least one data read phase of the cell, a potential VCELL = VDD.

- the means to apply said given potential being designed: to apply to the source electrode of the load transistors, during at least one data retention phase in the cell, a potential VDD - σV, in which σV > 0.

6. Random access memory cell according to claim 5, wherein σV = $V_{TN}$ in which $V_{TN}$ is the threshold voltage of a double gate transistor.

7. Random access memory cell according to any of claims 1 to 6, further comprising: means to cause said given potential VCELL to vary.

8. Random access memory cell according to claim 7, the means to cause said given potential to vary comprising:

- a polarization line (304) placed at a fixed potential,
- at least a first double-gate, switching transistor (305) and at least one second double-gate switching transistor (307) between the given polarization line (302) and said polarization line placed at said fixed potential, the first switching transistor being fabricated using technology complementing that of the second transistor, the gates of the first switching transistor and of the second switching transistor being connected together.

9. Random access memory cell according to claim 1, wherein the means to apply said given potential VCELL are said word line (WL).

10. Random access memory cell according to claim 9, said word line (WL) being connected to the source of the load transistors ($TL_L$, $TL_R$).

11. Random access memory cell according to claim 9 or 10, wherein the load transistors comprise a gate electrode connected to a potential VDD, the means to apply said given potential being designed: to apply to the source electrode of the load transistors, during at least one data write phase in the cell, a potential VCELL < VDD.

- the means to apply said given potential being designed: to apply to the source electrode of the load transistors, during at least one data read phase in the cell, a potential VCELL < VDD.
- the means to apply said given potential being designed: to apply to the source electrode of the load transistors, during at least one data retention phase of the cell, a potential VCELL = VDD.

12. Random access memory cell according to any of claims 9 to 11, the first access transistor comprising a second gate electrode connected to the second storage node, the second access transistor comprising a second gate electrode connected to the first storage node.

13. Random access memory cell according to claim 9, said word line (WL) being connected to the source of the driver transistors ($TD_L$, $TD_R$),

14. Random access memory cell according to claim 13, wherein the driver transistors comprise a gate electrode connected to a potential VSS, the means to apply said given potential being designed: during at least one data write phase in the cell, to apply to the source electrode of the driver transistors a potential VCELL > VSS,

- the driver transistors comprise a gate electrode connected to a potential VSS, the means to apply said given potential being designed: during at least one data retention phase of the cell, to apply to the source electrode of the driver transistors a potential VCELL = VSS.
- the means to apply said given potential being designed: during at least one data read phase in the cell, to apply to the source electrode of the driver transistors a potential VCELL > VSS.

**Patentansprüche**

1. SRAM-Speicherzelle, umfassen:

- einen ersten Doppelgate-Zugriffstransistor ($TA1_L$, $TA2_L$, $TA3_L$, $TA4_L$, $TA5_L$, $TA6_L$) und einen zweiten Doppelgate-Zugriffstransistor ($TA1_R$, $TA2_R$, $TA3_R$, $TA4_R$, $TA5_R$, $TA6_R$), jeweils angeordnet zwischen einer ersten Bitleitung ($BL_L$) und einem ersten Speicherknoten (L) und zwischen einer zweiten Bitleitung ($BL_R$) und einem zweiten Speicherknoten (R),

- eine Wortleitung (WL), verbunden mit einer ersten Gate-Elektrode des ersten Zugriffstransistors und mit einer ersten Gate-Elektrode des zweiten Zugriffstransistors,
- einen ersten Doppelgate-Ladetransistor $(TL1_L)$, $(TL2_L)$, $(TL3_L)$, $(TL4_L)$ und einen zweiten Doppelgate-Ladetransistor $(TL1_R)$, $(TL2_R)$, $(TL3_R)$, $(TL4_R)$,
- einen ersten Doppelgate-Durchlasstransistor $(TD1_L)$, $(TD2_L)$, $(TD3_L)$ und einen zweiten Doppelgate-Durchlasstransistor $(TD1_R)$, $(TD2_R)$, $(TD3_R)$,

wobei ein Bezugspotential (Vdd, Vss) an das zweite Gate der Ladetransistoren $(TL1_R)$, $(TL2_R)$, $(TL3_R)$, $(TL4_R)$ oder Durchlasstransistoren $(TD1_R)$, $(TD2_R)$, $(TD3_R)$ gelegt wird, **dadurch gekennzeichnet, dass** die Zelle außerdem umfasst: Einrichtungen zum Anlegen eines gegebenen variablen Potentials (VCELL) an wenigstens eine Source- oder Drain-Elektrode jedes Lade- oder Durchlasstransistors, und **dadurch**, dass das während der Schreibphasen der Zelle angelegte gegebene Potential VCELL unterschiedlich zum Referenzpotential (Vdd, Vss) vorgesehen ist und so, dass ein Durchlassstrom der Lade- oder Durchlasstransistoren erzeugt wird, der während der Schreibphasen schwächer ist als dann, wenn das gegebene Potential VCELL und das Referenzpotential (Vdd, Vss) gleich sind.

2. SRAM-Speicherzelle nach Anspruch 1, bei der die Einrichtungen zum Anlegen des genannten gegebenen Potentials (VCELL) durch eine zusätzliche Vorspannungsleitung (202, 302) gebildet werden.

3. SRAM-Speicherzelle nach einem der Ansprüche 1 oder 2, wobei die genannte zusätzliche Vorspannungsleitung (202, 302) mit der Source der Ladetransistoren $(TL2_L, TL2_R)$ verbunden ist.

4. SRAM-Speicherzelle nach Anspruch 3, außerdem umfassend:

- Einrichtungen, um während der Phasen des Einschreiben von Daten in die genannte Zelle eine Potentialdifferenz $V_{G1}$-$V_S$ wie etwa $V_{G1}$-$V_S = \sigma V$, mit $\sigma V > 0$ Volt, zwischen einer ersten Gate-Elektrode und der Source-Elektrode jedes der Ladetransistoren $(TL1_L, TL1_R, TL2_L, TL2_R)$ anzulegen,
- und/oder Einrichtungen, um während der Phasen des Auslesens von Daten aus der genannten Zelle eine Null-Potentialdifferenz $V_{G1}$-$V_S$ zwischen der genannten ersten Gate-Elektrode und der Source-Elektrode jedes der Ladetransistoren $(TL1_L, TL1_R, TL2_L, TL2_R)$ anzulegen,
- und/oder Einrichtungen, um während der Phasen des Haltens von Daten in der genannten Zelle eine Potentialdifferenz $V_{G1}$-$V_S$ wie etwa $V_{G1}$-$V_S = \sigma V$, mit $\sigma V > 0$ Volt, zwischen einer ersten Gate-Elektrode und der Source-Elektrode jedes der Ladetransistoren anzulegen.

5. SRAM-Speicherzelle nach Anspruch 3, bei der die Ladetransistoren $(TL1_L, TL1_R)$ eine mit einem Potential VDD verbundene Gate-Elektrode umfassen, wobei die Einrichtungen zum Anlegen des genannten gegebenen Potentials dazu vorgesehen sind:

- an die Source-Elektrode der Ladetransistoren während wenigstens einer Phase des Einschreibens von Daten in die Zelle ein Potential VCELL = VDD - $\sigma V$ mit $\sigma V > 0$ anzulegen,
- und/oder an die Source-Elektrode der Ladetransistoren während wenigstens einer Phase des Auslesens von Daten aus der Zelle ein Potential VCELL = VDD anzulegen,
- und/oder an die Source-Elektrode der Ladetransistoren während wenigstens einer Phase des Haltens von Daten in der Zelle ein Potential VDD - $\sigma V$ mit $\sigma V > 0$ anzulegen.

6. SRAM-Speicherzelle nach Anspruch 5, bei der $\sigma V = V_{TN}$ mit $V_{TN}$ als Schweflenspannung eines Doppelgatetransistors.

7. SRAM-Speicherzelle nach einem der Ansprüche 1 bis 6, außerdem umfassend: Einrichtungen zum Variieren des genannten gegebenen Potentials VCELL.

8. SRAM-Speicherzelle nach Anspruch 7, wobei die Einrichtungen zum Variieren des genannten gegebenen Potentials VCELL umfassen:

- eine auf ein festes Potential gelegte Vorspannungsleitung (304),
- wenigstens einen ersten Doppelgate-Unterbrechungstransistor (305) und wenigstens einen zweiten Doppelgate-Unterbrechungstransistor (307) zwischen der gegebenen Vorspannungsleitung (302) und der genannten, auf das genannte feste Potential gelegten Vorspannungsleitung, wobei der erste Unterbrechungstransistor eine zu der des zweiten Transistors komplementäre Technologie aufweist, und die Gates des ersten Unterbrechungstransistors und des zweiten Unterbrechungstransistors miteinander verbunden sind.

9. SRAM-Speicherzelle nach Anspruch 1, bei der die Einrichtungen zum Anlegen des genannten gegebenen Potentials VCELL die genannte Wortleitung (WL) sind.

10. SRAM-Speicherzelle nach Anspruch 9, wobei die genannte Wortleitung (WL) an die Ladetransistor-Source ($TL_L$, $TL_R$) angeschlossen ist.

11. SRAM-Speicherzelle nach einem der Ansprüche 9 oder 10, bei der die Ladetransistoren eine an ein Potential VDD angeschlossene Gate-Elektrode umfassen und die Einrichtungen zum Anlegen des genannten gegebenen Potentials dazu vorgesehen sind:

   - an die Source-Elektrode der Ladetransistoren während wenigstens einer Phase des Einschreibens von Daten in die Zelle ein Potential VCELL < VDD anzulegen,
   - und/oder an die Source-Elektrode der Ladetransistoren während wenigstens einer Phase des Auslesens von Daten aus der Zelle ein Potential VCELL < VDD anzulegen,
   - und/oder an die Source-Elektrode der Ladetransistoren während wenigstens einer Phase des Haltens von Daten in der Zelle ein Potential VCELL = VDD anzulegen.

12. SRAM-Speicherzelle nach einem der Ansprüche 9 bis 11, bei der der erste Zugrifftransistor eine an den zweiten Speicherknoten angeschlossene zweite Gate-Elektrode umfasst, wobei der zweite Zugrifftransistor eine an den ersten Speicherknoten angeschlossene zweite Gate-Elektrode umfasst.

13. SRAM-Speicherzelle nach Anspruch 9, wobei die genannte Wortleitung (WL) an die Source der Durchlasstransistoren ($TD_L$, $TD_R$) angeschlossen ist.

14. SRAM-Speicherzelle nach Anspruch 13, bei der die Durchlasstransistoren eine an ein Potential VSS angeschlossene Gate-Elektrode umfassen und die Einrichtungen zum Anlegen des genannten gegebenen Potentials dazu vorgesehen sind:

   - an die Source-Elektrode der Durchlasstransistoren während wenigstens einer Phase des Einschreibens von Daten in die Zelle ein Potential VCELL > VSS anzulegen,
   - und/oder an die Source-Elektrode der Durchlasstransistoren während wenigstens einer Phase des Haltens von Daten in der Zelle ein Potential VCELL = VSS anzulegen,
   - und/oder an die Source-Elektrode der Durchlasstransistoren während wenigstens einer Phase des Auslesens von Daten aus der Zelle ein Potential VCELL > VSS anzulegen.

**FIG. 1**

**FIG. 2**

120

WL  Vdd

ML_L    ML_R

L='1'    R='0'

MA_L    MA_R

MD_L    MD_R

M_eq

BL_L    BL_R

WL_eq

## FIG. 3

130

WL  Vdd

ML_L    ML_R

MA_L    L='1'    R='0'    MA_R

MD_L    MD_R

BL_L    BL_R

Vss

## FIG. 4

FIG. 5

FIG. 6

160

ML$_L$    ML$_R$

BL$_L$

MA$_L$    MA$_R$

L='1'    R='0'

BL$_R$

WL

# FIG. 7

200

202 WL    Vcell

Vdd

TL1$_L$    TL1$_R$

TA1$_L$    L='1'    R='0'    TA1$_R$

BL$_L$    BL$_R$

TD1$_L$    TD1$_R$

Vss

# FIG. 8

FIG. 9A

FIG. 9B

FIG. 10

FIG. 11A

FIG. 11B

FIG. 12A

302

# FIG. 12B

400

# FIG. 13

500

WL

Vdd

Vdd

TL3ₗ                    TL3ᵣ

TA5ₗ                    TA5ᵣ

L='1'          R='0'

BLₗ                    BLᵣ

TD2ₗ                    TD2ᵣ

Vss

# FIG. 14

600

Vdd

TL4ₗ                    TL4ᵣ

TA6ₗ                    TA6ᵣ

L='1'          R='0'

BLₗ                    BLᵣ

TD4ₗ                    TD4ᵣ

WL

# FIG. 15

**FIG. 16**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 005991192 A
- US 20070139072 A1

**Littérature non-brevet citée dans la description**

- **K. Itoh.** *VLSI Memory Chip Design,* 2001, 87-88
- **K. Itoh.** *VLSI Memory Design,* 1994
- **M. Reyboz et al.** Explicit Threshold Voltage Based Compact Model Of Independent Double Gate (IDG) MOSFET Including Short Channel Effects. *CEA*
- **Z. Guo ; S. Balasubramanian ; R. Ziatanovici ; T-J. King ; B. Nikoli'c.** *FinFET-Based SRAM Design,* 2005
- **M. Yamaoka ; K. Osada ; R. Tsuchiya ; M. Horiuchi ; S. Kirnura ; T. Kawahara.** Low power SRAM menu for SOC application using Yin-Yang-feedback memory cell technology. *Syrnp. VLSI Circuits Dig.,* 2004, vol. 18, 288-291
- **B. Giraud ; A. Vladimirescu ; A. Amara.** A Comparative Study of 6T and 4T SRAM Cells in Double Gate CMOS with Statistical Variation. *ISCAS,* Mai 2007
- **E. Seevinck Sr. et al.** Static-noise margin analysis of MOS SRAM ceils. *IEEE JSSCC,* 1987, vol. 22, 748-754
- **B. Giraud ; A. Vladirnirescu ; A. Arnara.** Indepth Analysis of 4T SRAM Cells in Double-Gate CMOS. *ICICDT,* Mai 2007